# EUROPÄISCHE PATENTSCHRIFT

(11) **EP 0 542 096 B1**
(45) Veröffentlichungstag und Bekanntmachung des Hinweises auf die Patenterteilung: **14.09.1994**
(21) Anmeldenummer: 92118779.5
(22) Anmeldetag: 02.11.1992
(51) Int. Cl.: H05K 13/02

(54) **Einrichtung zum Speichern, Vereinzeln und Zuführen von als Schüttgut aufnehmbaren Teilen**
Device for storing, isolating and delivering components loadable in bulk
Dispositif pour emmagasiner, séparer et délivrer des composants fournis en vrac

(30) Priorität: 11.11.1991 DE 4137024
(43) Veröffentlichungstag der Anmeldung: 19.05.1993
(73) Patentinhaber: SIEMENS AKTIENGESELLSCHAFT, 80333 München (DE)
(72) Erfinder: Hanslbauer, Ernst, W-8037 Olching (DE)

(56) Entgegenhaltungen:
- EP-A- 0 016 368
- EP-A- 0 300 191
- US-A- 4 678 073
- US-A- 4 905 445

## Beschreibung

Bei der automatischen Bestückung von Leiterplatten oder Keramiksubstraten mit SMD-Bauelementen, wie Widerständen, Kondensatoren, Dioden, Transistoren, Chips und dgl. werden aus stranggepreßten Profilen bestehende Förderschienen nebeneinander auf dem Rütteltisch eines Vibrationslängsförderers angeordnet. Die am hinteren Ende der Förderschienen in Vorratsbehältern als Schüttgut gespeicherten SMD-Bauelemente werden durch die Schwingbewegungen des Rütteltisches zum vorderen Ende der Förderschienen hin befördert, an welchen durch eine Abflachung bzw. Ausfräsung eine Entnahmeöffnung für die Bauelemente gebildet ist. Die Entnahme der in diesen Entnahmepositionen bereitgestellten SMD-Bauelemente erfolgt dann jeweils bei Stillstand des Rütteltisches über einen Bestückkopf, welcher das Bauelement mit einer Saugpipette erfaßt, mit Hilfe von Hebeln zentriert und auf einer vorbestimmten Stelle der Leiterplatte oder des Keramiksubstrats ablegt. Da von derartigen Bestückautomaten eine extrem hohe Bestücksicherheit gefordert wird, muß der auf die Entnahmeposition der Vibrationslängsförderer programmierte Bestückkopf die Bauteile dort auch stets in der richtigen Lage antreffen. Für diese richtige Lage der Bauelemente sorgen im Anfangsbereich der Förderbahn des Vibrationslängsförderers angeordnete Masken, die als Sperre für falsch liegende Bauelemente wirken und die Bauelemente nur einzeln durchlassen. Der Durchtrittsquerschnitt dieser Masken ist also derart auf die Form und Größe der Bauelemente abgestimmt, daß diese nur in der richtigen Lage und nacheinander hindurchtreten und zur Entnahmeposition transportiert werden können. Aus der EP-A-0 216 203 ist es bekannt, bei derartigen Einrichtungen einen eventuellen Stau falsch liegender Bauelemente vor der Maske durch die Einleitung von Druckluft aufzulösen.

Aus der EP-A-0 016 368 oder der EP-A-0 300 191 sind sog. Vibrationsrechteckförderer bekannt, bei welchen durch zwei parallel nebeneinander angeordnete Vibrationslängsförderer mit entgegengesetzten Förderrichtungen ein rechteckförmiger Umlauf der Bauelemente im Vorratsbehälter erzeugt wird. Hierdurch werden einerseits vor der Maske falsch liegende Bauelemente weitertransportiert und andererseits stets neue Bauelemente an die Maske herangeführt.

Bei den bekannten Einrichtungen zum Speichern, Vereinzeln und Zuführen von als Schüttgut aufnehmbaren SMD-Bauelementen befindet sich also immer eine vorgegebene Menge der SMD-Bauelemente in einem Vorratsbehälter, wobei die Vereinzelung und der Transport der SMD-Bauelemente durch Vibration oder durch Einleiten von Druckluft vorgenommen wird. Dieses Vibrieren, Verwirbeln oder Umströmen mit Druckluft des gesamten Vorrats an SMD-Bauelementen führt jedoch zu einer Verschmutzung durch Abrieb und damit zu Lötproblemen.

Der im Anspruch 1 angegebenen Erfindung liegt das Problem zugrunde, eine Einrichtung zum Speichern, Vereinzeln und Zuführen von SMD-Bauelementen zu schaffen, bei welcher eine Verschmutzung der SMD-Bauelemente durch Abrieb zumindest weitgehend vermieden wird.

Die mit der Erfindung erzielten Vorteile bestehen insbesondere darin, daß durch das Trennen des Vorratsbehälters von der Förder- und Vereinzelungseinrichtung nur noch eine kleine Menge an SMD-Bauelementen durch Vibrieren und Verwirbeln aneinander reibt und die Verschmutzung dadurch praktisch vernachlässigbar gering ist. Die Hauptmenge an SMD-Bauelementen im Vorratsbehälter wird nur dann kurzfristig einer Vibration oder Verwirbelung ausgesetzt, wenn bei Bedarf der Förder- und Vereinzelungseinrichtung neue SMD-Bauelemente zugeführt werden müssen.

Vorteilhafte Ausgestaltungen der Erfindung sind in den Ansprüchen 2 bis 5 angegeben.

Die Ausgestaltung nach Anspruch 2 ermöglicht durch das Aufsetzen einer Vorratskassette ein besonders einfaches Nachfüllen der Vorratsbehälter bzw. eine Vergrößerung der Vorratsmenge.

Die Weiterbildung nach Anspruch 3 ermöglicht auf einfache Weise und mit einer bewährten Technik den Transport der Teile aus dem Vorratsbehälter zu der Förder- und Vereinzelungseinrichtung.

Ist die Förder- und Vereinzelungseinrichtung gemäß Anspruch 4 durch einen Vibrationsrechteckförderer gebildet, so ergibt sich eine besonders hohe Zuverlässigkeit bei der Bereitstellung der Teile.

Die Ausgestaltung nach Anspruch 5 ermöglicht eine besonders einfache und zuverlässige Überwachung der Vorratsmenge in der Förder- und Vereinzelungseinrichtung.

Ein Ausführungsbeispiel der Erfindung ist in der Zeichnung dargestellt und wird im folgenden näher beschrieben.

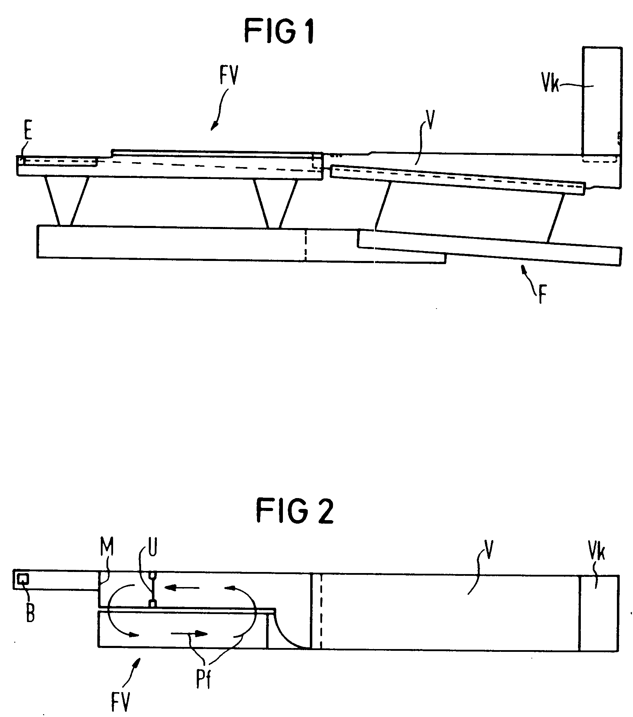

Die Figuren 1 und 2 zeigen in stark vereinfachter schematischer Darstellung eine Einrichtung zum Speichern, Vereinzeln und Zuführen von als Schüttgut vorliegenden SMD-Bauelementen in der Seitenansicht bzw. in der Draufsicht.

Die dargestellte Einrichtung umfaßt einen auf einer Fördereinrichtung F angeordneten Vorratsbehälter V, eine auf den Vorratsbehälter V aufschiebbare Vorratskassette Vk, eine sich an den Auslauf des Vorratsbehälters V anschließende Förder- und Vereinzelungseinrichtung FV und eine der Förder- und Vereinzelungseinrichtung FV zugeordnete Überwachungseinrichtung U.

In der durch einen Vibrationsrechteckförderer gebildeten Förder- und Vereinzelungseinrichtung FV befindet sich eine kleine Menge an SMD-Bauelementen B, die entsprechend den Pfeilen Pf durch Vibration rechteckförmig umlaufen und über eine Maske M lagerichtig nacheinander einer mit E bezeichneten Entnahmeposition zugeführt werden. Die durch eine Lichtschranke gebildete Überwachungseinrichtung U erfaßt den Füllstand der Bauelemente in der Förder- und Vereinzelungseinrichtung FV. Bei Unterschreitung einer Mindestmenge an SMD-Bauelementen B in der Förder- und Vereinzelungseinrichtung FV wird die durch einen Vibrationslängsförderer gebildete Fördereinrichtung F durch die Überwachungseinrichtung U kurzzeitig eingeschaltet und es werden neue SMD-Bauelemente B der Förder- und Vereinzelungseinrichtung FV zugeführt.

Die Förder- und Vereinzelungseinrichtung FV, der abnehmbare Vorratsbehälter V und die aufschiebbare Vorratskassette Vk sind in geschlossener Bauweise ausgeführt, so daß der Zutritt von Schmutz oder anderen Bauelementen mit Sicherheit ausgeschlossen werden kann.

Die aus Fig. 1 ersichtliche geneigte Aufstellung der Fördereinrichtung F ermöglicht eine keilförmige Ausbildung des Vorratsbehälters V und damit eine Vergrößerung der Vorratsmenge.

Werden zwei oder mehrere der vorstehend beschriebenen Einrichtungen zum Speichern, Vereinzeln und Zuführen von als Schüttgut aufnehmbaren SMD-Bauelementen nebeneinander angeordnet, so können die Förder- und Vereinzelungseinrichtungen FV und die Fördereinrichtungen F jeweils durch gemeinsame elektromagnetische Schwingantriebe betrieben werden.

## Patentansprüche

1. Einrichtung zum Speichern, Vereinzeln und Zuführen von als Schüttgut aufnehmbaren Teilen, insbesondere von SMD-Bauelementen (B), mit
- einem Vorratsbehälter (V) zur Aufnahme des Schüttguts,
- einer dem Vorratsbehälter (V) zugeordneten Fördereinrichtung (F)
- einer sich an den Auslauf des Vorratsbehälters (V) anschließenden Förder- und Vereinzelungseinrichtung (FV), mit welcher die Teile nacheinander und lagerichtig einer Entnahmeposition (E) zugeführt werden und mit
- einer Überwachungseinrichtung (U), die bei Unterschreitung einer Mindestmenge an Teilen in der Förder- und Vereinzelungsvorrichtung (FV) die Fördereinrichtung (F) des Vorratsbehälters (V) betätigt.

2. Einrichtung nach Anspruch 1,
**dadurch gekennzeichnet**,
daß auf den Vorratsbehälter (V) eine Schüttgut enthaltende Vorratskassette (VK) aufgesetzt ist.

3. Einrichtung nach Anspruch 1 oder 2,
**dadurch gekennzeichnet,**
daß die Fördereinrichtung (F) durch einen Vibrationslängsförderer gebildet ist.

4. Einrichtung nach einem der vorhergehenden Ansprüche,
**dadurch gekennzeichnet,**
daß die Förder- und Vereinzelungseinrichtung (FV) durch einen Vibrationsrechteckförderer mit einem rechteckförmigen Umlauf der Teile und einer vor der Entnahmeposition (E) angeordneten Maske (M) zum Vereinzeln der Teile gebildet ist.

5. Einrichtung nach einem der vorhergehenden Ansprüche,
**dadurch gekennzeichnet,**
daß die Überwachungseinrichtung (U) durch eine Lichtschranke gebildet ist.

## Claims

1. Device for storing, separating, and feeding parts which can be accommodated as bulk material, preferably SMD-components (B), having
- one supply container (V) for accommodating the bulk material,
- one conveying device (F) assigned to the supply container (V)
- one conveying and separating device (FV) joined to the outlet of the supply container (V), by means of which the parts are fed to a withdrawal position (E) one after the other and in the correct position, and having
- a monitoring device (U) which actuates the conveying device (F) of the supply container (V) if the amount of parts in the conveying and separating device (FV) falls below the minimum.

2. Device according to Claim 1, characterized in that a supply box (VK) containing bulk material is placed on the supply container (V).

3. Device according to Claim 1 or 2, characterized in that the conveying device (F) is formed by a vibrating longitudinal conveyor.

4. Device according to one of the preceding claims, characterized in that the conveying and separating device (FV) is formed by a vibrating rectangular-part-feeding conveyor having a rectangular flow of parts, and a mask (M), which is arranged downstream of the withdrawal position (E), for separation the parts.

5. Device according to one of the preceding claims, characterized in that the monitoring device (U) is formed by a photoelectric barrier.

## Revendications

1. Dispositif pour emmagasiner, individualiser et envoyer des pièces pouvant être réceptionnées en vrac, notamment des composants SMD (B), comportant
- un réservoir (V) de réception des pièces en vrac,
- un dispositif de convoyage (F) associé au réservoir (V),
- un dispositif de convoyage et d'individualisation (FV), qui se raccorde à la sortie du réservoir (V) et par lequel les pièces sont envoyées successivement et en position correcte à un poste de prélèvement (E), et
- un dispositif de contrôle (U), qui, lorsque le nombre de pièces dans le dispositif de convoyage et d'individualisation (FV) devient inférieur à un minimum, actionne le dispositif de convoyage (F) du réservoir (V).

2. Dispositif suivant la revendication 1, caractérisé par le fait qu'une cassette de stockage (VK) contenant les pièces en vrac est posée sur le réservoir (V).

3. Dispositif suivant la revendication 1 ou 2, caractérisé par le fait que le dispositif de convoyage (F) est un convoyeur longitudinal vibrant.

4. Dispositif suivant l'une des revendications précédentes, caractérisé par le fait que le dispositif de convoyage et d'individualisation (FV) est un convoyeur rectangulaire vibrant avec une circulation rectangulaire des pièces et ayant un masque (M) disposé en avant de la position de prélèvement (E) et destiné à individualiser les pièces.

5. Dispositif suivant l'une des revendications précédentes, caractérisé par le fait que le dispositif de contrôle (U) est un relais photoélectrique.
